# EUROPEAN PATENT APPLICATION

(11) **EP 4 770 317 A1**
(43) Date of publication of application: **01.07.2026**
(21) Application number: 25218422.1
(22) Date of filing: 25.11.2025
(51) Int. Cl.: H10D 30/01, H10D 30/00

(54) **SELECTIVE OXIDATION-BASED CAVITY SPACERS FOR NANOWIRE FIELD EFFECT TRANSISTORS**

(30) Priority: 26.12.2024 US 202419002222
(71) Applicant: INTEL Corporation, Santa Clara, CA 95054 (US)
(72) Inventor: MEHANDRU, Rishabh, Portland, OR 97221 (US); NASKAR, Sudipto, Portland, OR 97229 (US); HATTENDORF, Michael L., Portland, OR 97229 (US); KEYS, Patrick H., Beaverton, OR 14730 (US); CEA, Stephen M., Hillsboro, OR 97124 (US)
(74) Representative: 2SPL Patentanwälte PartG mbB

(57) **Abstract**

Devices, transistor structures, systems, and techniques are described herein related to gate all around field effect transistors having a stack of nanowires (i.e., semiconductor structures) contacted by epitaxial source and drain structures at opposite ends of the nanowires. The transistors include a gate structure vertically between the nanowires. Spacer structures of silicon germanium oxide separate the ends of the nanowires spacer and separate the source and drains structures from the gate structure.

## Description

### BACKGROUND

Higher performance, lower cost, increased miniaturization, and greater density of integrated circuits (ICs) are ongoing goals of the electronics industry. To maintain the pace of increasing transistor performance, for example, multi-gate transistors such as gate-all-around (GAA) or nanowire transistors are being deployed. In such devices, the gate structure surrounds the channel region on all sides of each nanowire (or nanoribbon) of semiconductor material for improved drive current, device control, and other advantages. The nanowires or nanoribbons of semiconductor material are contacted on opposite sides by source and drain structures, which may be epitaxially grown materials.

Currently, there is a lack of PMOS epitaxial strain in nanowires or nanoribbons due to multiple epi growth fronts meeting and causing defects during growth of the source and drain structures. This can be improved by not having ribbons formed at the time of epitaxial source drain structure formation. However, the resultant structure has a significant increase in overlap capacitance (COV), which degrades device performance. It is with respect to these and other considerations that the present improvements have been needed. Such improvements may become critical as the desire to deploy multi-gate transistor structures such as nanowire or nanoribbon field effect transistors becomes more widespread.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG.1 is a flow diagram illustrating exemplary methods for forming transistor structures with spacer structures oxidized from remaining sacrificial materials after nanowire release;
FIGS. 2, 3, 4, 5, 6, and 7 are cross-sectional side views of example transistor structures as particular fabrication operations of the methods of FIG. 1 are performed;
FIG. 8 is a cross-sectional side view of the transistor structure of FIG. 7 incorporated in a multi-layer integrated circuit device structure;
FIG. 9 illustrates exemplary systems employing transistor structures having a stack of semiconductor structures and spacer structures including a compound of silicon, germanium, and oxygen between ends of the semiconductor structures and between the gate structure and source and drain structures of the transistor structures; and
FIG. 10 is a functional block diagram of an electronic computing device, all in accordance with at least some embodiments of the present disclosure.

### DETAILED DESCRIPTION

One or more embodiments or implementations are now described with reference to the enclosed figures. While specific configurations and arrangements are discussed, it should be understood that this is done for illustrative purposes only. Persons skilled in the relevant art will recognize that other configurations and arrangements may be employed without departing from the spirit and scope of the description. It will be apparent to those skilled in the relevant art that techniques and/or arrangements described herein may also be employed in a variety of other systems and applications other than what is described herein.

Reference is made in the following detailed description to the accompanying drawings, which form a part hereof, wherein like numerals may designate like parts throughout to indicate corresponding or analogous elements. It will be appreciated that for simplicity and/or clarity of illustration, elements illustrated in the figures have not necessarily been drawn to scale. For example, the dimensions of some of the elements may be exaggerated relative to other elements for clarity. Further, it is to be understood that other embodiments may be utilized, and structural and/or logical changes may be made without departing from the scope of claimed subject matter. It should also be noted that directions and references, for example, up, down, top, bottom, over, under, and so on, may be used to facilitate the discussion of the drawings and embodiments and are not intended to restrict the application of claimed subject matter. Therefore, the following detailed description is not to be taken in a limiting sense and the scope of claimed subject matter defined by the appended claims and their equivalents.

In the following description, numerous details are set forth. However, it will be apparent to one skilled in the art, that the present invention may be practiced without these specific details. In some instances, well-known methods and devices are shown in block diagram form, rather than in detail, to avoid obscuring the present invention. Reference throughout this specification to "an embodiment" or "one embodiment" means that a particular feature, structure, function, or characteristic described in connection with the embodiment is included in at least one embodiment of the invention. Thus, the appearances of the phrase "in an embodiment" or "in one embodiment" in various places throughout this specification are not necessarily referring to the same embodiment of the invention. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description of the invention and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items. Herein, the term "predominantly" indicates not less than 50% of a particular material or component while the term "substantially pure" indicates not less than 99% of the particular material or component and the term "pure" indicates not less than 99.9% of the particular material or component. Unless otherwise indicated, such material percentages are based on atomic percentage. Herein the term concentration is used interchangeably with material percentage and also indicates atomic percentage unless otherwise indicated.

The terms "coupled" and "connected," along with their derivatives, may be used herein to describe structural relationships between components. It should be understood that these terms are not intended as synonyms for each other. Rather, in particular embodiments, "connected" may be used to indicate that two or more elements are in direct physical or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause an effect relationship, an electrical relationship, a functional relationship, etc.).

The terms "over," "under," "between," "on", and/or the like, as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features. The term immediately adjacent indicates such features are in direct contact. Furthermore, the terms "substantially," "close," "approximately," "near," and "about," generally refer to being within +/- 10% of a target value. The term layer as used herein may include a single material or multiple materials. As used in throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C. The terms "lateral", "laterally adjacent" and similar terms indicate two or more components are aligned along a plane orthogonal to a vertical direction of an overall structure. As used herein, the terms "monolithic", "monolithically integrated", and similar terms indicate the components of the monolithic overall structure form an indivisible whole not reasonably capable of being separated.

Devices, transistor structures, integrated circuit dies, apparatuses, systems, and techniques are described herein related to gate-all-around field effect transistors (GAA-FETs) having silicon germanium oxide spacer structures vertically separating the ends of the nanowires nanoribbons and between the gate structure and the source and drain structure of the transistors.

As discussed, multi-gate transistors such as gate-all-around (GAA) or nanowire transistors are being deployed in advanced integrated circuit devices. As used herein, the terms nanowire, nanoribbon, stacked semiconductor structure, and similar terms are used substantially interchangeably to indicate a semiconductor material that extends from a source to a drain such that the semiconductor material is one of two or more such material structures that are separated and vertically aligned. The multiple semiconductor material structures each couple to the same source and drain, and are vertically separated by a gate structure, which may include a gate dielectric and a gate electrode. Thereby, the field effect transistor or device includes a source, a drain, and a stack of semiconductor structures extending between the source and the drain. The source and drain are epitaxial to the semiconductor structures. As used herein the term epitaxial to or similar terms indicate the materials are substantially lattice matched. The stack of semiconductor structures (e.g., two to about eight semiconductor structures) are controlled by the same gate electrode, and work in concert as the channel of the device. As used herein, the term channel region of a semiconductor structure indicates a region of a material layer adjacent to a gate dielectric and gate electrode that is to be controlled by the gate electrode to switch the transistor structure in operation. Notably, a region of a material layer need not be in operation to be characterized as a channel region, channel material, or the like. The term semiconductor structure is used broadly to include nanowires, nanoribbons, and similar terms.

Current GAA-FETs have difficulties including a lack of PMOS epitaxial strain in nanowires due to growing the source and drain epitaxial materials from multiple semiconductor structures that are separated by dielectric spacer materials. The multiple growth fronts then meet and cause defects during growth of the source and drain structures. This can be improved by not having the dielectric spacer materials present during the epitaxial source drain structure formation. However, the resultant structure has a significant increase in overlap capacitance (COV), which degrades device performance.

In some embodiments, source and drain epitaxial material structures are grown from an interleaved multilayer stack of semiconductor materials (e.g., silicon) and sacrificial materials (e.g., silicon germanium) in the absence of spacer dielectric during the growth. This forms defect free, high-quality epitaxial source and drain materials (e.g., source and drain epi) and locks in the advantageous PMOS epitaxial strain in the semiconductor materials. For example, a single growth front is provided for each of the epitaxial source and drain structures. After nanowire release by removal of a portion or majority of the sacrificial materials, material structures of the sacrificial materials remain at the ends of the nanowires adjacent the source and drain structures.

The remaining material structures (e.g., silicon germanium) are then oxidized after nanowire release using process conditions which oxidize silicon germanium preferentially compared to silicon resulting in capacitance recovery and both better power and higher speed for transistor operations. The process conditions, for example, include a relatively low temperature (e.g., 500°C to 700°C) oxidation at a controlled time limit (e.g., not more than 30 minutes). For example, due to the germanium content of the material structures, which acts as an oxidation catalyst, oxidation of silicon germanium is much more rapid than that of silicon, and the discussed process conditions form spacer structures that are a compound of silicon, germanium, and oxygen while the exposed silicon semiconductor materials include little or no oxidized material. Thereby, the discussed techniques thermally grow an oxide preferentially in unreleased SiGe remaining post-nanowire release. Higher thermal oxidation rates of SiGe provide a selective oxidation of SiGe compared to the exposed Si of the nanowires.

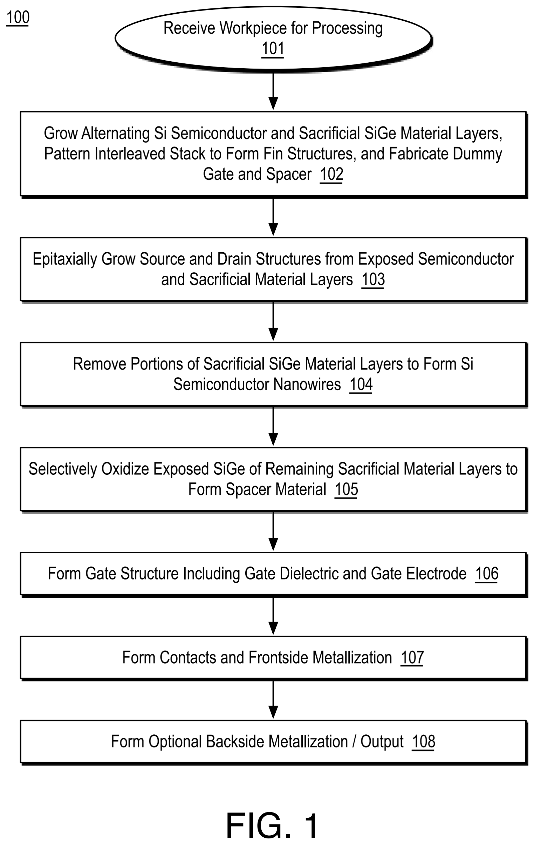

FIG.1 is a flow diagram illustrating exemplary methods 100 for forming transistor structures with spacer structures oxidized from remaining sacrificial materials after nanowire release, arranged in accordance with at least some implementations of the present disclosure. For example, methods 100 may be implemented to fabricate transistor structure 700 or any other transistor structures discussed herein. In the illustrated implementation, methods 100 may include one or more operations as illustrated by operations 101-108. However, embodiments herein may include additional operations, certain operations being omitted, or operations being performed out of the order provided.

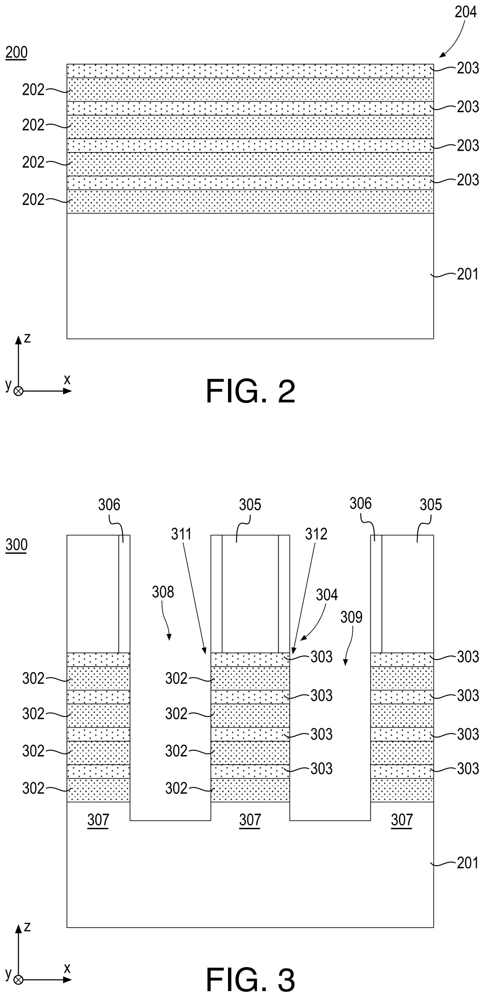

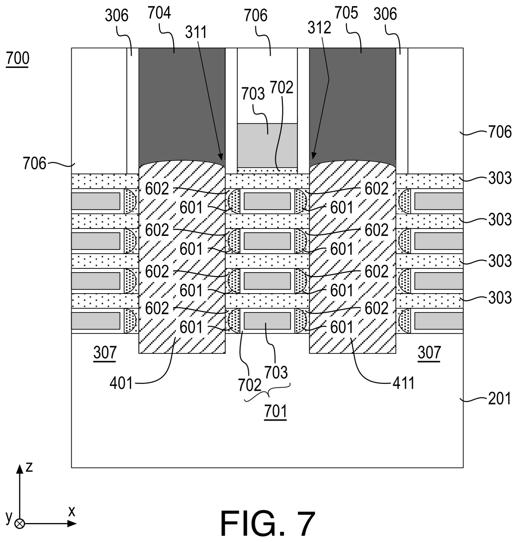

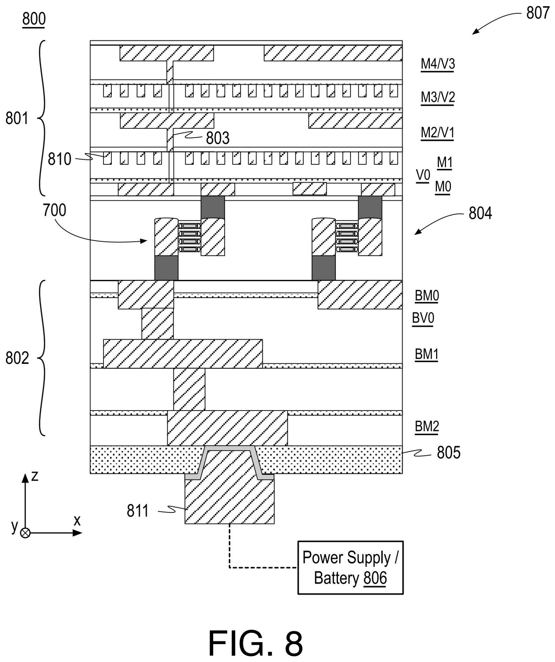

FIGS. 2, 3, 4, 5, 6, and 7 are cross-sectional side views of example transistor structures as particular fabrication operations of methods 100 are performed, arranged in accordance with at least some implementations of the present disclosure. For example, methods 100 may be deployed to fabricate the transistor structures of FIG. 7, or any other transistor structures discussed herein. FIG. 8 is a cross-sectional side view of the transistor structure of FIG. 7 incorporated in a multi-layer integrated circuit device structure, arranged in accordance with at least some implementations of the present disclosure. Although illustrated with respect to the transistor structure of FIG. 7, any transistor structure discussed herein may be deployed in the context of the multi-layer integrated circuit device structure of FIG. 8.

Processing begins at operation 101, where a workpiece such as a substrate is received for processing. The substrate may include any suitable substrate as discussed herein such as a silicon wafer or the like. In some embodiments, the substrate includes underlying devices or electrical interconnects. Processing continues at operation 102, where alternating layers of semiconductor material layers and sacrificial layers are formed over the workpiece or substrate, the alternating (or interleaved) layers of semiconductor material layers and sacrificial layers are patterned to form fin structures of the interleaved stack of semiconductor material layers and sacrificial layers, and dummy gate and spacer structures are formed.

The alternating layers of semiconductor material layers and sacrificial layers may be formed using any suitable technique or techniques such as epitaxial growth techniques, deposition techniques or the like. The semiconductor material layers, and sacrificial layers may include any suitable materials and may have any thickness characteristics. The alternating layers of semiconductor material layers and sacrificial layers may be patterned into any number of fins using any suitable technique or techniques such as lithography and etch techniques. When patterned, the resultant semiconductor structures or nanoribbons are defined for use in a transistor structure. In some embodiments, the patterning includes one or more etches such to define the fin critical dimensions of the semiconductor material layers. Notably, the sacrificial layers are not recessed relative to the semiconductor material layers such that both may be used as an epitaxial growth surface in subsequent processing.

FIG. 2 is a cross-sectional side view of an example transistor structure 200 after growth of an interleaved stack 204 of alternating semiconductor material layers 203 and sacrificial material layers 202 over a substrate 201. Substrate 201 may include any suitable material or materials and, in some embodiments, substrate 201 includes a material or materials having the same or a similar composition with respect to semiconductor material layers 203. In some embodiments, substrate 201 and semiconductor material layers 203 include a Group IV material (e.g., silicon). In some embodiments, substrate 201 and semiconductor material layers 203 include a substantially monocrystalline material. In some embodiments, substrate 201 includes a buried insulator layer (e.g., SiO₂), for example, of a semiconductor-on-insulator (SOI) substrate and/or isolation insulator regions and the like.

Semiconductor material layers 203 may include any number of layers for the formation of semiconductor structures, channel semiconductors, nanoribbons, or nanowires over substrate 201 such as two, three, four, five, six, seven, eight or more layers with even numbers of semiconductor material layers 203 typically being deployed. Semiconductor material layers 203 are separated and interleaved with sacrificial material layers 202. Portions of sacrificial material layers 202 will be removed and replaced by one or more gate structures inclusive of, for example, gate dielectric materials and gate electrode materials. Remaining portions of sacrificial material layers 202 will be oxidized to form spacer structures that are oxidized compound of the material of sacrificial material layers 202.

Interleaved stack 204 of semiconductor material layers 203 and sacrificial material layers 202 may be formed using any suitable technique or techniques such as those discussed with respect to operation 102. Semiconductor material layers 203 and sacrificial material layers 202 are bulk layers that may be later patterned. In some embodiments, semiconductor material layers 203 are silicon such as monocrystalline silicon and sacrificial material layers 202 are silicon germanium. Semiconductor material layers 203 and sacrificial material layers 202 may have any suitable thicknesses (i.e., measured in the z-dimension) such as thicknesses in the range of about 5 to 12 nm. In some embodiments, each of sacrificial material layers 202 have a greater thickness than any of semiconductor material layers 203. For example, sacrificial material layers 202 may each of a thickness of not less than 25% greater than that of any of semiconductor material layers 203.

FIG. 3 is a cross-sectional side view of an example transistor structure 300 similar to transistor structure 200, after the patterning of interleaved stack 204 to form patterned stacks 304, and formation of dummy gate structure 305 and spacer 306. In some embodiments, interleaved stack 204 are first etched to define fins extending in the x-dimension. Dummy gate structures 305, which extend in the y-dimension, may then be formed and patterned (i.e., by bulk deposition and patterning), and spacers 306 may then be formed. Subsequently, the fins may then be patterned under dummy gate structures 305 and spacers 306 to define patterned stacks 304 of sacrificial material layers 302 and semiconductor material layers 303. Notably, patterned stacks 304 may also be characterized as fins having a source to drain length is defined in the x-dimension. The source to drain length may be any suitable length such as a length in the range of 3 to 20 nm. For example, sacrificial material layers 302 and semiconductor material layers 303 may have length in the x-dimension of not less than 3 nm and not more than 20 nm. However, any source to drain lengths may be used. Also as shown, the patterning of interleaved stack 204 may form subfins 307 of substrate 201 due to openings 308, 309 extending into substrate 201. In some embodiments, opening 308 corresponds to a source opening 308 and opening 309 corresponds to a drain opening 309. Dummy gate structures 305 and spacer 306 such as polysilicon and dielectric materials, respectively.

In the context of methods 100, sacrificial material layers 302 and semiconductor material layers 303 provide a single front or substantially planar material within openings 308, 309 for the growth of epitaxial material that provides a strain on resultant nanowires. For example, patterned stacks 304 include a first end 311 and a second end 312 such that second end 312 is laterally opposite first end 311. As used herein the term lateral indicates a direction or dimension in the x-y plane and the term vertical indicates a direction or dimension in the z-direction. Such terms comport with their use the art with the positive z-direction being a build-up direction and a frontside of the transistor structure and the negative z-direction being a backside of the transistor structure. By not recessing sacrificial material layers 302 and filling the recess with dielectric material, subsequent epitaxial materials may be grown from first ends 311 and second ends 312 of both semiconductor material layers 303 and sacrificial material layers 302 with significant lattice matching. Such growth conditions offer advantages with respect to the quality of the resulting epitaxial source and drain materials and the resultant strain of semiconductor material layers 303.

Returning to FIG. 1, processing continues at operation 103, where epitaxial source and drain materials are epitaxially grown or deposited via the exposed ends of the stacks of interleaved semiconductor material layers and sacrificial material layers. In some embodiments, a single bulk material is grown or deposited from the interleaved semiconductor material layers and sacrificial material layers. In some embodiments, an epitaxial nucleation layer may be grown or deposited, followed by bulk growth or deposition. In some embodiments, the epitaxial nucleation layer and bulk epitaxial materials are grown or deposited in the same process chamber using differing deposition parameters. The source and drain materials may be any suitable materials such as doped silicon, doped silicon germanium, or the like. The epitaxial source and drain materials may be deposited using any suitable technique or techniques such as chemical vapor deposition (CVD) including dopant materials.

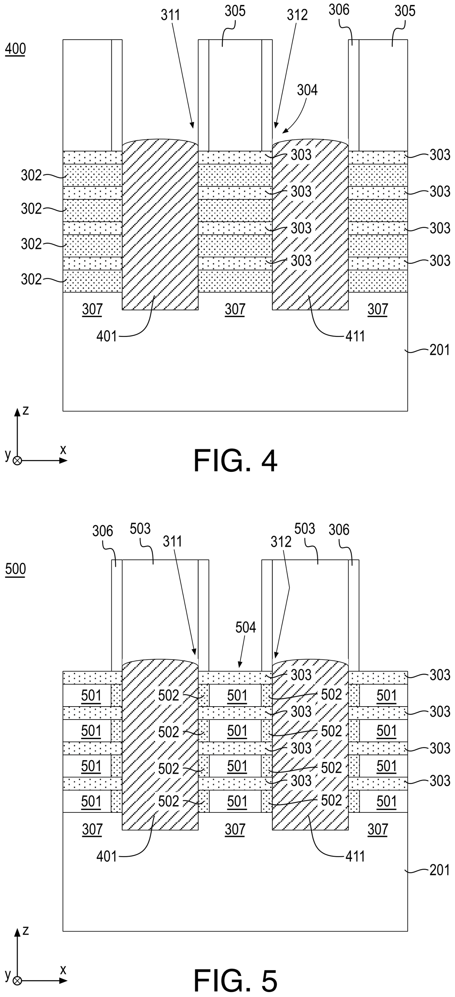

FIG. 4 is a cross-sectional side view of an example transistor structure 400 similar to transistor structure 300, after the epitaxial growth of source structure 401 and drain structure 411. In some embodiments, source structure 401 and drain structure 411 each include an epitaxial nucleation layer (not shown) and a bulk epitaxial material. For example, epitaxial nucleation layers may have a lower dopant concentration than a bulk of the epitaxial material of source structure 401 and drain structure 411.

Source structure 401 and drain structure 411 may be fabricated using CVD or other epitaxial deposition techniques. Source structure 401 and drain structure 411 are epitaxial to exposed ends 311, 312 of patterned stacks 304 including ends 311, 312 of each of sacrificial material layers 302 and semiconductor material layers 303. Due to the presence of ends 311, 312 of each of sacrificial material layers 302 (instead of a spacer material), the epitaxial material of source structure 401 and drain structure 411 is high quality, low-defect and locks in strain to semiconductor material layers 303 prior to nanowire release. As discussed, source structure 401 and drain structure 411 may be epitaxial bodies such as doped epitaxial silicon or doped epitaxial silicon and germanium (SiGe), for example source structure 401 and drain structure 411 may each include silicon and a dopant or silicon, germanium, and a dopant. In some embodiments, the dopant is boron or gallium for PMOS devices and phosphorous or arsenic for NMOS devices, although other suitable dopants may be used.

Returning to FIG. 1, processing continues at operation 104, where portions of the interleaved sacrificial material layers are removed using selective etch techniques such as selective wet etch techniques. After selective removal, portions of the sacrificial materials remain at or near the source structure and the drain structure as well as the semiconductor material layers remain. For example, an etch selectivity exists between the silicon germanium of the sacrificial materials and the silicon of the semiconductor material layers (e.g., silicon germanium sacrificial material layers and substantially pure or pure silicon semiconductor material layers). Furthermore, the ends of the sacrificial materials near the source structure and the drain structure are difficult to access using the etch and remain after the etch processing. The removal of the majority of the interleaved sacrificial material layers provides for nanowire release or exposure of the semiconductor material layers, as well as a remaining silicon germanium material between the ends of the released nanowires immediately adjacent the source structure and the drain structure.

FIG. 5 is a cross-sectional side view of an example transistor structure 500 similar to transistor structure 400, after formation of dielectric fill material 503, which may be any suitable material such as a silicon oxide, silicon nitride, silicon oxynitride, or the like, and after removal of portions of sacrificial material layers 302 to release or expose semiconductor material layers 303 and to form lateral material structures 502 and openings 501. As discussed, a portion or majority of sacrificial material layers 302 may be removed using any suitable technique or techniques such as selective wet etch techniques, such that the processing leaves lateral material structures 502 on and immediately adjacent source structure 401 and drain structure 411. Lateral material structures 502 are to be oxidized to form spacer materials that isolate or electrically separate source structure 401 and drain structure 411 from later formed gate structures for improved transistor performance.

As shown, removal of portions of sacrificial material layers 302 releases semiconductor material layers 303 to provide a stack of semiconductor structures 504 with the stack including vertically aligned semiconductor material layers 303. Vertically aligned semiconductor material layers 303 may be characterized as semiconductor structures, nanowires, nanoribbons, channel semiconductors, or the like. Each semiconductor structure of stack of semiconductor structures 504 is coupled with and epitaxial to source structure 401 and drain structure 411 at opposite lateral ends 311, 312 of stack of semiconductor structures 504.

Furthermore, lateral material structures 502 have the material contents of semiconductor material layers 303 and are epitaxial to source structure 401 and drain structure 411. Therefore, a difference in material is evident between lateral material structures 502 (e.g., silicon germanium) and semiconductor material layers 303 (e.g., silicon). Prior to formation of gate structures in openings 501, lateral material structures 502 may be selectively oxidized due to the difference in material between lateral material structures 502 and semiconductor material layers 303.

Returning to FIG. 1, processing continues at operation 105, where the remaining portions of the sacrificial materials from operation 104 (e.g., silicon germanium materials) are selectively oxidized relative to the released nanowires (e.g., silicon materials) to form spacer materials. The selective oxidation is performed at a relatively low temperate for a relatively small amount of time such that little or none of the released nanowires (e.g., silicon materials) oxidize while the remaining portions of the sacrificial materials (e.g., silicon germanium materials) are oxidized at a significant rate. For example, oxide formation is much faster in the silicon germanium materials relative to the silicon materials due to germanium effectively acting as an oxidation catalyst. The oxidation may be performed using thermal oxidization in a furnace or other process chamber at a process temperature in the range of 500°C to 700°C using, for example, pure oxygen or a mixture of oxygen and water vapor. As used herein, the process temperature is used in its ordinary meaning to indicate a peak temperature or an average temperature of the workpiece. Similarly, the term process time is used in its ordinary meaning to indicate a duration the workpiece is exposed to the working gas or gases within the process chamber.

As discussed, methods 100 include receiving a multilayer stack of semiconductor structures interleaved with a stack of sacrificial structures, such that the semiconductor structures are substantially pure or pure silicon, and the sacrificial structures are each silicon and germanium such as a silicon germanium compound. A source structure and a drain structure are epitaxially grown from opposing first and second ends of the multilayer stack and portions the sacrificial structures are removed to form lateral material structures adjacent the first and second ends of the multilayer stack. The remaining sacrificial material structures are then oxidized to form spacer structures comprising a compound of silicon, germanium, and oxygen.

In some embodiments, the oxidation of the silicon germanium material is an oxidation at an average temperature of not less than 500°C and not more than 700°C. In some embodiments, the oxidation of the silicon germanium material is an oxidation at an average temperature of not more than 700°C. In some embodiments, the oxidation of the silicon germanium material is an oxidation at an average temperature of not more than 600°C. In some embodiments, the oxidation of the silicon germanium material is an oxidation at a peak temperature of not less than 500°C and not more than 700°C. In some embodiments, the oxidation of the silicon germanium material is an oxidation at a peak temperature of not more than 700°C. In some embodiments, the oxidation of the silicon germanium material is an oxidation at a peak temperature of not more than 600°C. In some embodiments, the oxidation of the silicon germanium material is an oxidation for a duration of not more than 60 minutes. In some embodiments, the oxidation of the silicon germanium material is an oxidation for a duration of not more than 30 minutes. In some embodiments, the oxidation of the silicon germanium material is an oxidation for a duration of not more than 20 minutes. In some embodiments, the oxidation of the silicon germanium material is an oxidation for a duration of not less than 5 minutes and not more than 30 minutes.

Any combination of such temperatures and durations may be used. In some embodiments, the oxidation of the silicon germanium material is an oxidation at an average temperature or a peak temperature of not more than 700°C for not more than 30 minutes. In some embodiments, the oxidation of the silicon germanium material is an oxidation at an average temperature or a peak temperature of not more than 700°C for not more than 20 minutes. In some embodiments, the oxidation of the silicon germanium material is an oxidation at an average temperature or a peak temperature of not more than 700°C for not more than 15 minutes.

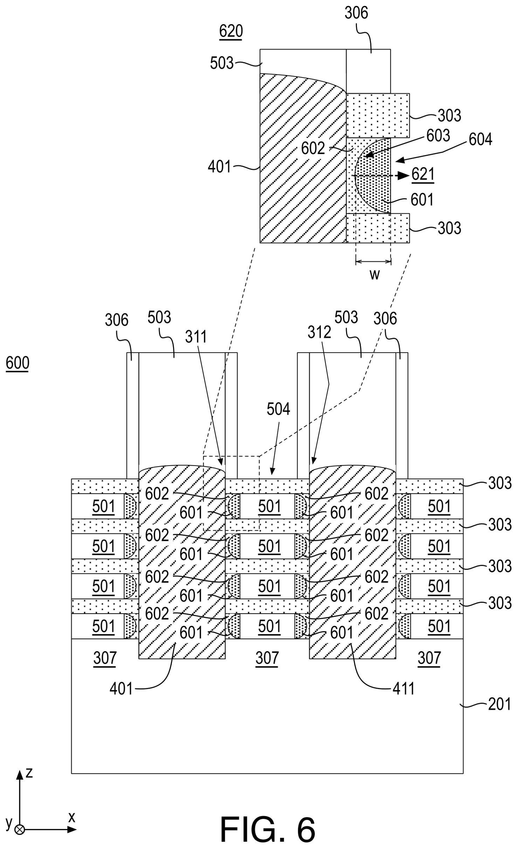

FIG. 6 is a cross-sectional side view of an example transistor structure 600 similar to transistor structure 500, after oxidation of lateral material structures 502 to form spacer structures 601 that are a compound of silicon, germanium, and oxygen such as a silicon germanium oxide. Spacer structures 601 may be formed using any suitable process conditions discussed with respect to operation 105. Spacer structures 601 may have any suitable composition of silicon, germanium, and oxygen. As discussed further herein below, a gate structure is formed in openings 501. It is noted that spacer structures 601 and other components substantially maintain the characteristic discussed with respect to FIG. 6.

For example, a transistor structure may include a stack of semiconductor structures 504 each including silicon. For example, each of semiconductor material layers 303 may be substantially pure or pure silicon. As shown in FIG. 6, due to the selection of the process parameters of oxidation, little or no oxide is formed on semiconductor material layers 303. The transistor structure further includes source structure 401 epitaxial to lateral end 311 of each of semiconductor material layers 303 and drain structure 411 epitaxial to second end 312 of each of the semiconductor material layers 303. As discussed further herein below, a gate structure is formed vertically between semiconductor material layers 303. Furthermore, the transistor structure includes spacer structures 601 laterally between the gate structure (see FIG. 7) and source structure 401 and drain structure 411. As discussed, spacer structure 601 is a compound of silicon, germanium, and oxygen.

As shown in enlarged view 620, in some embodiments, a portion of lateral material structures 502 are oxidized to form spacer structures 601 while another portion of lateral material structures 502 remain as second spacer structures 602, such that second spacer structures 602 are a substantially pure or pure compound of silicon germanium (i.e., absent oxygen). As used herein, a compound or material is absent a species when there is not more than a trace (i.e., <0.01%) of the particular species. Spacer structures 601 may be a compound of any suitable percentages of silicon, germanium, and oxygen. In some embodiments, spacer structures 601 are not less than 5% oxygen and a balance of silicon and germanium. In some embodiments, spacer structures 601 are not less than 10% oxygen and a balance of silicon and germanium. In some embodiments, spacer structures 601 are not less than 15% oxygen and a balance of silicon and germanium. The balance of silicon and germanium may be any suitable ratios of silicon and germanium. In some embodiments, the balance of silicon and germanium is a ratio of not less than 1.25:1 silicon to germanium. In some embodiments, the balance of silicon and germanium is a ratio of not less than 1.5:1 silicon to germanium. In some embodiments, the balance of silicon and germanium is a ratio of not less than 2:1 silicon to germanium.

In some embodiments, spacer structures 601 have a decreasing germanium concentration gradient 621. For example, along germanium concentration gradient 621, the concentration of germanium may reduce toward an outer surface 604 of spacer structures 601. The reduction may be any monotonically reducing function of germanium concentration to lateral distance. For example, spacer structure 601 may have a first portion adjacent source structure 401 (or drain structure 411) and a second portion adjacent outer surface 604 (and an eventual gate structure), such that the first portion has a greater germanium concentration than the second portion.

With continued reference to enlarged view 620, spacer structures 601 may have a concave surface 603 extending toward source structure 401 (and drain structure 411). For example, the discussed techniques provide for a dielectric material between laterally between the gate structure (see FIG. 7) and source structure 401 and drain structure 411 such that the dielectric spacer structures are formed using selective oxidation due to the germanium content of the oxidized material. Due to germanium acting as a catalyst, diffusion during the oxidation process may cause concave surface 603 due the material being consumed during oxidation faster at a center of the oxidizing material (i.e., of lateral material structures 502) and slower at the edges. Spacer structures 601 may have any suitable lateral width w. In some embodiments, lateral width w of spacer structures is not less than 2 nm and not more than 10 nm. In some embodiments, lateral width w of spacer structures is not less than 4 nm and not more than 10 nm. In some embodiments, lateral width w of spacer structures is not less than 5 nm and not more than 9 nm. In some embodiments, lateral width w of spacer structures is not less than 6 nm and not more than 8 nm. In some embodiments, lateral width w of spacer structures is not more than 9 nm. In some embodiments, lateral width w of spacer structures is not more than 8 nm. Other lateral widths w may be used.

Furthermore, although illustrated with each outer surface 604 of spacer structures 601 being substantially aligned with an outer surface of spacer 306, in some embodiments, outer surface 604 of spacer structures 601 may be recessed with respect to the outer surface of spacer 306 or outer surface 604 of spacer structures 601 may extend beyond the outer surface of spacer 306. Furthermore, some variation may be evident due to the discussed etch processing and subsequent oxidation processing. In some embodiments, outer surface 604 of the uppermost of spacer structures 601 is recessed with respect to the outer surface of spacer 306 and outer surface 604 of the lowermost of spacer structures 601 extends beyond the outer surface of spacer 306.

Returning to FIG. 1, processing continues at operation 106, where the sacrificial materials removed at operation 104 are replaced by a gate structure, which may include a gate dielectric material on at least portions of the semiconductor structures, and a gate electrode (e.g., gate metal) on the gate dielectric material. The gate structure may be formed using any suitable technique or techniques. In some embodiments, the gate dielectric material is formed using conformal deposition processing, and the gate electrode is formed by conformal deposition (of a work function metal) followed by metal fill. However, other fabrication techniques may be used.

Processing continues at operation 107, where any or all of the source structure, drain structure, and gate structure are contacted by frontside metal contacts using any suitable technique or techniques such as patterning and metal deposition processing as is known in the art. For example, frontside contacts may be made to any one or more of the source, drain, and gate of the transistor structure being fabricated. For example, the transistor structure is a three terminal device to be contacted at the source, drain, and gate, and any of these may be contacted from the frontside or backside of the device structure. The frontside contacts are then interconnected by metallization layers over the frontside contact. In some embodiments, the gate and drain of the transistor structure are contacted from the frontside to provide signal routing and the source of the transistor structure is contacted from the backside to provide power delivery. However, any interconnect routing may be used.

FIG. 7 is a cross-sectional side view of an example transistor structure 700 similar to transistor structure 700, after formation of gate structure 701, which includes a gate dielectric layer 702 and a gate electrode 703, and after formation of a source contact 704, a drain contact 705, and a gate contact (not shown) within a dielectric material 706, which may be any suitable material such as a silicon oxide, silicon nitride, silicon oxynitride, or the like. As discussed, gate structure 701 may be formed by conformal deposition of gate dielectric layer 702 followed by conformal deposition of a work function metal of gate electrode 703 followed by metal fill of a remainder of gate electrode 703.

In some embodiments, gate dielectric layer 702 of gate structure 701 includes a layer that is or includes aluminum oxide, hafnium oxide, zirconium oxide, titanium silicon oxide, hafnium silicon oxide, or silicon nitride. For example, gate dielectric layer 702 may include aluminum and oxygen; hafnium and oxygen; zirconium and oxygen; titanium, silicon, and oxygen; hafnium, silicon, and oxygen; or silicon and nitrogen. In some embodiments, gate electrode 703 of gate structure 701 includes a work function layer of platinum, nickel, titanium nitride, or tantalum nitride and a fill metal such as tungsten. However, other material systems may be used.

As also shown in FIG. 7, transistor structure 700 includes frontside source contact 704 in contact with source structure 401 and frontside drain contact 705 in contact with drain structure 411. Transistor structure 700 may further include a frontside gate contact (not shown) in contact with gate electrode 703. For example, the gate contact may be into or out of the page of the illustrated cross section. Frontside source contact 704, frontside drain contact 705, and the frontside gate contact may be formed using operations known in the art such as lithography patterning of vias and via fill and optional planarization. Such components may include any suitable materials. For example, frontside source contact 704, frontside drain contact 705, and the frontside gate contact may include a liner material such as titanium nitride and a fill metal such as tungsten. However, other material systems may be used. Over transistor structure 700, frontside metallization layers may be formed using any suitable technique or techniques such as dual damascene techniques, single damascene techniques, subtractive metallization patterning techniques, or the like. Frontside metallization layers are illustrated herein below with respect to FIG. 8. In some embodiments, only frontside metallization layers are used. In other embodiments, after fabrication of the frontside metallization layers, the workpiece may be mounted to a carrier wafer and backside contacts and metallization layers may be fabricated.

Returning to FIG. 1, processing continues at operation 108, where backside metallization is optionally fabricated opposite the frontside metallization with respect to a device layer including the discussed transistor structures, additional fabrication processes may be completed, and the resultant structure may be output. Such processing may include backend processing, dicing, packaging, assembly, and so on. The resultant device (e.g., integrated circuit die) may then be implemented in any suitable form factor device such as a laptop, a netbook, a notebook, an ultrabook, a smartphone, a tablet, a personal digital assistant, an ultra-mobile PC, a mobile phone, a desktop computer, a server, a printer, a scanner, a monitor, a set-top box, an entertainment control unit, a digital camera, a portable music player, a digital video recorder, or the like.

FIG. 8 is a cross-sectional side view of a multi-layer integrated circuit device structure 800 incorporating transistor structure 700, arranged in accordance with at least some embodiments of the present disclosure. Although illustrated and discussed with respect to transistor structure 700 of FIG. 7 altered with use of a backside source contact, any transistor structure discussed herein such transistor structure 700 having a frontside source contact may be deployed in the context of multi-layer integrated circuit device structure 800. As shown, multi-layer integrated circuit device structure 800 is incorporated in integrated circuit (IC) die 807 such that multi-layer integrated circuit device structure 800 includes frontside metallization layers 801 (or frontside interconnect layers) and backside metallization layers 802 (or backside interconnect layers). Frontside metallization layers 801 and backside metallization layers 802 may be formed using any suitable technique or techniques such as dual damascene techniques, single damascene techniques, subtractive metallization patterning techniques, or the like. In some embodiments, backside metallization layers 802 are not deployed.

In some embodiments, interconnectivity, signal routing, power-delivery, and the like may be provided by frontside metallization layers 801. Adjacent metallization layers, such as metallization interconnects 810, are interconnected by vias, such as vias 803, that may be characterized as part of the metallization layers or between the metallization layers. As shown, in some embodiments, frontside metallization layers 801 are formed over and immediately adjacent transistor structure 700. In the illustrated example, frontside metallization layers 801 include M0, V0, M1, M2/V1, M3/V2, and M4/V3. However, frontside metallization layers 801 may include any number of metallization layers such as six, eight, or more metallization layers.

Similarly, backside metallization layers 802, may be used for interconnectivity, signal routing, power-delivery, and any other suitable electrical connectivity. In some embodiments, frontside metallization layers 801 are used exclusively for signal routing and backside metallization layers 802 are used exclusively for power delivery. However, any interconnection architecture may be used. In the illustrated example, package level interconnects 811 are provided on or over a device backside as bumps over a passivation layer 805. However, package level interconnects 811 may be provided using any suitable interconnect structures such as bond pads, solder bumps, etc. As shown, in some embodiments, backside metallization layers 802 are formed over and immediately adjacent transistor structure 700 such that a device layer 804 including transistor structure 700 is between frontside metallization layers 801 and backside metallization layers 802. In the illustrated example, backside metallization layers 802 include BM0, BM1, and BM2 with intervening via layers. However, backside metallization layers 802 may include any number of metallization layers such as three, four, or more metallization layers.

In some embodiments, a transistor structure such as transistor structure 700 is deployed in a monolithic integrated circuit (IC) die 807 including a gate-all-around field effect transistor structure (e.g., a GAA-FET), the GAA-FET transistor structure including any of the discussed components and characteristics. As shown, a power supply 806 may be coupled to IC die 807, such that power supply 806 may include a battery, voltage converter, power supply circuitry, or the like.

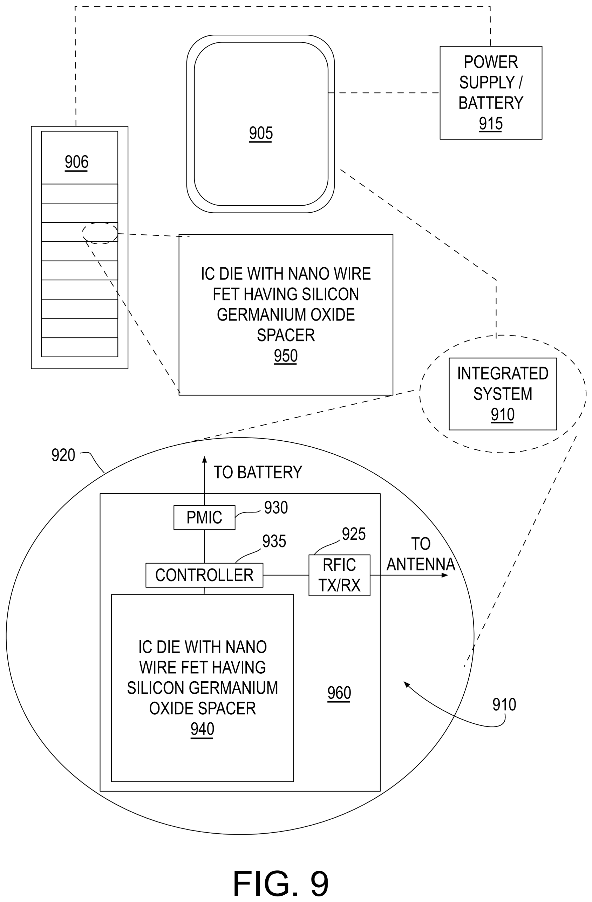

FIG. 9 illustrates exemplary systems employing transistor structures having a stack of semiconductor structures and spacer structures including a compound of silicon, germanium, and oxygen between ends of the semiconductor structures and between the gate structure and source and drain structures of the transistor structures, in accordance with some embodiments. The system may be a mobile computing platform 905 and/or a data server machine 906, for example. Either may employ a component assembly including an IC die employing transistor structures having a stack of semiconductor structures and spacer structures including a compound of silicon, germanium, and oxygen between ends of the semiconductor structures and between the gate structure and source and drain structures of the transistor structures as described elsewhere herein. Server machine 906 may be any commercial server, for example including any number of high-performance computing platforms disposed within a rack and networked together for electronic data processing, which in the exemplary embodiment includes an IC die assembly 950 with an IC die employing transistor structures having a stack of semiconductor structures and spacer structures including a compound of silicon, germanium, and oxygen between ends of the semiconductor structures and between the gate structure and source and drain structures of the transistor structures as described elsewhere herein. Mobile computing platform 905 may be any portable device configured for each of electronic data display, electronic data processing, wireless electronic data transmission, or the like. For example, mobile computing platform 905 may be any of a tablet, a smart phone, a laptop computer, etc., and may include a display screen (e.g., a capacitive, inductive, resistive, or optical touchscreen), a chip-level or package-level integrated system 910, and a battery 915. Although illustrated with respect to mobile computing platform 905, in other examples, chip-level or package-level integrated system 910 and a battery 915 may be implemented in a desktop computing platform, an automotive computing platform, an internet of things platform, or the like. As discussed below, in some examples, the disclosed systems may include a sub-system 960 such as a system on a chip (SOC) or an integrated system of multiple ICs, which is illustrated with respect to mobile computing platform 905.

Whether disposed within integrated system 910 illustrated in expanded view 920 or as a stand-alone packaged device within data server machine 906, sub-system 960 may include memory circuitry and/or processor circuitry 940 (e.g., RAM, a microprocessor, a multi-core microprocessor, graphics processor, etc.), a power management integrated circuit (PMIC) 930, a controller 935, and a radio frequency integrated circuit (RFIC) 925 (e.g., including a wideband RF transmitter and/or receiver (TX/RX)). As shown, one or more IC dies, such as memory circuitry and/or processor circuitry 940 may be fabricated and implemented such that one or more have an IC die employing transistor structures having a stack of semiconductor structures and spacer structures including a compound of silicon, germanium, and oxygen between ends of the semiconductor structures and between the gate structure and source and drain structures of the transistor structures as described herein. In some embodiments, RFIC 925 includes a digital baseband and an analog front end module further comprising a power amplifier on a transmit path and a low noise amplifier on a receive path). Functionally, PMIC 930 may perform battery power regulation, DC-to-DC conversion, etc., and so has an input coupled to battery 915, and an output providing a current supply to other functional modules. As further illustrated in FIG. 9, in the exemplary embodiment, RFIC 925 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. Memory circuitry and/or processor circuitry 940 may provide memory functionality for sub-system 960, high level control, data processing and the like for sub-system 960. In alternative implementations, each of the SOC modules may be integrated onto separate ICs coupled to a package substrate, interposer, or board.

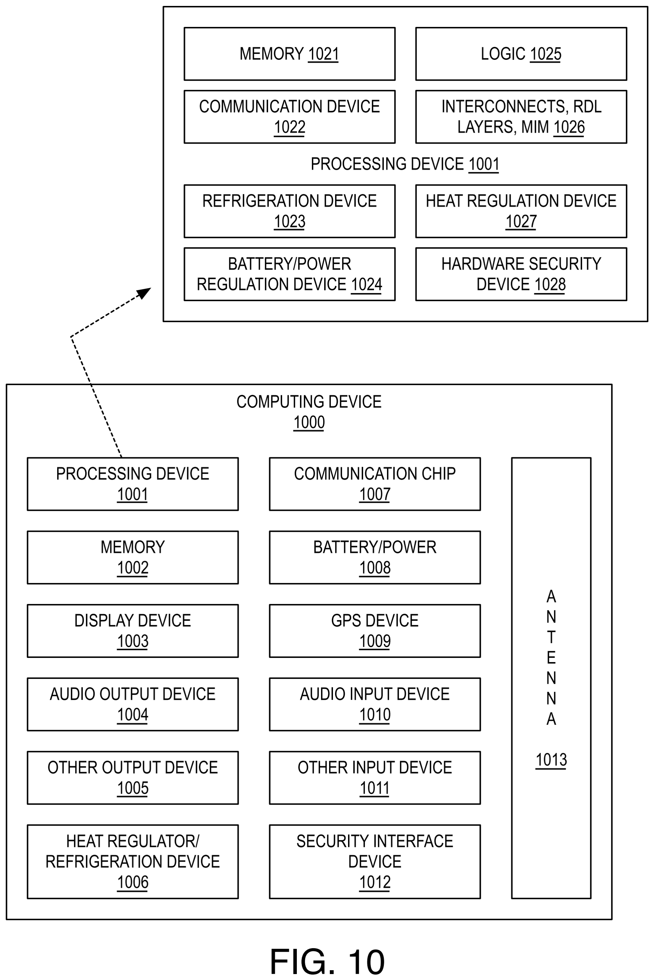

FIG. 10 is a block diagram of a computing device 1000, in accordance with some embodiments. For example, one or more components of computing device 1000 may include any of the transistor structures having a stack of semiconductor structures and spacer structures including a compound of silicon, germanium, and oxygen between ends of the semiconductor structures and between the gate structure and source and drain structures of the transistor structures as discussed elsewhere herein. A number of components are illustrated in FIG. 10, but any one or more of these components may be omitted or duplicated, as suitable for the application. In some embodiments, some of the components included in computing device 1000 may be attached to one or more printed circuit boards (e.g., a motherboard). In some embodiments, various ones of these components may be fabricated onto a single system-on-a-chip (SoC) die or implemented with a disintegrated plurality of chiplets or tiles packaged together. Any of such packaged components may include a transistor structures having a stack of semiconductor structures and spacer structures including a compound of silicon, germanium, and oxygen between ends of the semiconductor structures and between the gate structure and source and drain structures of the transistor structures, for example, as discussed herein. Additionally, in various embodiments, computing device 1000 may not include one or more of the components illustrated in FIG. 10, but computing device 1000 may include interface circuitry for coupling to the one or more components. For example, computing device 1000 may not include a display device 1003, but may include display device interface circuitry (e.g., a connector and driver circuitry) to which display device 1003 may be coupled.

Computing device 1000 may include a processing device 1001 (e.g., one or more processing devices). As used herein, the term processing device or processor indicates a device that processes electronic data from registers and/or memory to transform that electronic data into other electronic data that may be stored in registers and/or memory. Processing device 1001 may include a memory 1021, a communication device 1022, a refrigeration/active cooling device 1023, a battery/power regulation device 1024, logic 1025, interconnects 1026, a heat regulation device 1027, and a hardware security device 1028.

Processing device 1001 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable compute units.

Processing device 1001 may include a memory 1002, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, processing device 1001 shares a package with memory 1002. This memory may be used as cache memory and may include embedded dynamic random-access memory (eDRAM) or spin transfer torque magnetic random-access memory (STT-M RAM).

Computing device 1000 may include a heat regulation/refrigeration device 1006. Heat regulation/refrigeration device 1006 may maintain processing device 1001 (and/or other components of computing device 1000) at a predetermined low temperature during operation. This predetermined low temperature may be any temperature discussed elsewhere herein.

In some embodiments, computing device 1000 may include a communication chip 1007 (e.g., one or more communication chips). For example, the communication chip 1007 may be configured for managing wireless communications for the transfer of data to and from computing device 1000. The term "wireless" and its derivatives may be used to describe circuits, devices, systems, methods, techniques, communications channels, etc., that may communicate data through the use of modulated electromagnetic radiation through a nonsolid medium.

Computing device 1000 may include any photonics structure discussed herein that may facilitate communication between one or more instances of processing device 1001 and/or one or more instances of memory 1002, for example.

Computing device 1000 may include battery/power circuitry 1008. Battery/power circuitry 1008 may include one or more energy storage devices (e.g., batteries or capacitors) and/or circuitry for coupling components of computing device 1000 to an energy source separate from computing device 1000 (e.g., AC line power).

Computing device 1000 may include a display device 1003 (or corresponding interface circuitry, as discussed above). Display device 1003 may include any visual indicators, such as a heads-up display, a computer monitor, a projector, a touchscreen display, a liquid crystal display (LCD), a light-emitting diode display, or a flat panel display, for example.

Computing device 1000 may include an audio output device 1004 (or corresponding interface circuitry, as discussed above). Audio output device 1004 may include any device that generates an audible indicator, such as speakers, headsets, or earbuds, for example.

Computing device 1000 may include an audio input device 1010 (or corresponding interface circuitry, as discussed above). Audio input device 1010 may include any device that generates a signal representative of a sound, such as microphones, microphone arrays, or digital instruments (e.g., instruments having a musical instrument digital interface (MIDI) output).

Computing device 1000 may include a global positioning system (GPS) device 1009 (or corresponding interface circuitry, as discussed above). GPS device 1009 may be in communication with a satellite-based system and may receive a location of computing device 1000, as known in the art.

Computing device 1000 may include another output device 1005 (or corresponding interface circuitry, as discussed above). Examples include an audio codec, a video codec, a printer, a wired or wireless transmitter for providing information to other devices, or an additional storage device.

Computing device 1000 may include another input device 1011 (or corresponding interface circuitry, as discussed above). Examples may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 1000 may include a security interface device 1012. Security interface device 1012 may include any device that provides security measures for computing device 1000 such as intrusion detection, biometric validation, security encode or decode, managing access lists, malware detection, or spyware detection.

Computing device 1000 may include an antenna 1013. Antenna 1013 may include any device that translates electrical current to radio waves and/or translates radio waves to electrical current.

Computing device 1000, or a subset of its components, may have any appropriate form factor, such as a server or other networked computing component, a mobile device, a printer, a scanner, a monitor, a set-top box, an entertainment control unit, a vehicle control unit, a digital camera, a digital video recorder, or a wearable computing device.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the invention is not limited to the embodiments so described, but can be practiced with modification and alteration without departing from the scope of the appended claims. For example, the above embodiments may include specific combinations of features as further provided below.

The following pertain to exemplary embodiments.

In one or more first embodiments, an apparatus comprises a stack of semiconductor structures each comprising silicon, a source structure epitaxial to a first end of each of the semiconductor structures and a drain structure epitaxial to a second end, laterally opposite the first end, of each of the semiconductor structures, a gate structure vertically between each of the semiconductor structures, and a spacer structure laterally between the gate structure and one of the source structure or the drain structure, the spacer structure comprising a compound of silicon, germanium, and oxygen.

In one or more second embodiments, further to the first embodiments, the spacer structure comprises not less than 10% oxygen.

In one or more third embodiments, further to the first or second embodiments, the spacer structure comprises a decreasing germanium concentration gradient extending from the source structure or the drain structure to the gate structure.

In one or more fourth embodiments, further to the first through third embodiments, the spacer structure comprises a first portion adjacent the source structure or the drain structure and a second portion adjacent the gate structure, such that the first portion has a greater germanium concentration than the second portion.

In one or more fifth embodiments, further to the first through fourth embodiments, the spacer structure comprises a concave surface extending toward the source structure or the drain structure.

In one or more sixth embodiments, further to the first through fifth embodiments, the apparatus further comprises a second spacer structure laterally between the spacer structure and the source structure or the drain structure, such that the source structure or the drain structure is epitaxial to the second spacer structure.

In one or more seventh embodiments, further to the first through sixth embodiments, the second spacer structure comprises silicon and germanium and is absent oxygen.

In one or more eighth embodiments, further to the first through seventh embodiments, the spacer structure has a lateral width extending between the gate structure and the source structure or the drain structure of not more than 9 nm.

In one or more ninth embodiments, further to the first through eighth embodiments, the apparatus further comprises an integrated circuit (IC) die comprising the stack of semiconductor structures, the source structure, the drain structure, the gate structure, and the spacer structure, and a power supply coupled to the IC die.

In one or more tenth embodiments, an apparatus comprises a stack of semiconductor structures each comprising silicon, a source structure epitaxial to a first end of each of the semiconductor structures and a drain structure epitaxial to a second end, opposite the first end, of each of the semiconductor structures, a first spacer structure adjacent to the first ends of the semiconductor structures and a second spacer structure each to the second ends of the semiconductor structures, the first spacer structure and the second spacer structure each comprising silicon, germanium, and not less than 10% oxygen, and a gate structure vertically between the semiconductor structures and laterally between the first spacer structure and the second spacer structure.

In one or more eleventh embodiments, further to the tenth embodiments, the first spacer structure comprises a first portion adjacent the source structure and a second portion adjacent the gate structure, such that the first portion has a greater germanium concentration than the second portion.

In one or more twelfth embodiments, further to the tenth or eleventh embodiments, the first spacer structure comprises a concave surface extending toward the source structure.

In one or more thirteenth embodiments, further to the tenth through twelfth embodiments, the apparatus further comprises a third spacer structure laterally between the first spacer structure and the source structure, such that the source structure is epitaxial to the second spacer structure.

In one or more fourteenth embodiments, further to the tenth through thirteenth embodiments, the second spacer structure comprises silicon and germanium and is absent oxygen.

In one or more fifteenth embodiments, further to the tenth through fourteenth embodiments, the first spacer structure has a lateral width extending between the gate structure and the source structure of not more than 9 nm.

In one or more sixteenth embodiments, further to the tenth through fifteenth embodiments, the apparatus further comprises an integrated circuit (IC) die comprising the stack of semiconductor structures, the source structure, the drain structure, the gate structure, the first spacer structure, and the second spacer structure, and a power supply coupled to the IC die.

In one or more seventeenth embodiments, a method comprises receiving a multilayer stack comprising a stack of semiconductor structures interleaved with a stack of sacrificial structures, the semiconductor structures each comprising silicon and the sacrificial structures each comprising silicon and germanium, epitaxially growing a source structure and a drain structure from opposing first and second ends of the multilayer stack, removing portions the sacrificial structures to form lateral material structures adjacent the first and second ends of the multilayer stack, oxidizing the lateral material structures to form spacer structures comprising a compound of silicon, germanium, and oxygen, and forming a gate structure vertically between the stack of semiconductor structures and laterally adjacent the spacer structures.

In one or more eighteenth embodiments, further to the seventeenth embodiments, said oxidizing the spacer structures comprises oxidation at an average temperature of not more than 700°C for not more than 30 minutes.

In one or more nineteenth embodiments, further to the seventeenth or eighteenth embodiments, the oxidation comprises a peak temperature of not less than 500°C and not more than 700°C.

In one or more twentieth embodiments, further to the seventeenth through nineteenth embodiments, after said oxidizing, a portion of at least one of the lateral material structures remains adjacent at least one of the spacer structures, the portion of the at least one of the lateral material structures substantially absent oxygen.

It will be recognized that the invention is not limited to the embodiments so described, but can be practiced with modification and alteration without departing from the scope of the appended claims. For example, the above embodiments may include specific combination of features. However, the above embodiments are not limited in this regard and, in various implementations, the above embodiments may include undertaking only a subset of such features, undertaking a different order of such features, undertaking a different combination of such features, and/or undertaking additional features than those features explicitly listed. The scope of the invention should, therefore, be determined with reference to the appended claims, along with the full scope of equivalents to which such claims are entitled.

## Claims

1. An apparatus, comprising:
a stack of semiconductor structures each comprising silicon;
a source structure epitaxial to a first end of each of the semiconductor structures and a drain structure epitaxial to a second end, laterally opposite the first end, of each of the semiconductor structures;
a gate structure vertically between each of the semiconductor structures; and
a spacer structure laterally between the gate structure and one of the source structure or the drain structure, the spacer structure comprising a compound of silicon, germanium, and oxygen.

2. The apparatus of claim 1, wherein the spacer structure comprises not less than 10% oxygen.

3. The apparatus of claim 1 or 2, wherein the spacer structure comprises a decreasing germanium concentration gradient extending from the source structure or the drain structure to the gate structure.

4. The apparatus of claim 1, 2 or 3, wherein the spacer structure comprises a first portion adjacent the source structure or the drain structure and a second portion adjacent the gate structure, wherein the first portion has a greater germanium concentration than the second portion.

5. The apparatus of any one of claims 1 to 4, wherein the spacer structure comprises a concave surface extending toward the source structure or the drain structure.

6. The apparatus of any one of claims 1 to 5, further comprising a second spacer structure laterally between the spacer structure and the source structure or the drain structure, wherein the source structure or the drain structure is epitaxial to the second spacer structure.

7. The apparatus of claim 6, wherein the second spacer structure comprises silicon and germanium and is absent oxygen.

8. The apparatus of any one of claims 1 to 7, wherein the spacer structure has a lateral width extending between the gate structure and the source structure or the drain structure of not more than 9 nm.

9. The apparatus of any one of claims 1 to 8, further comprising:
an integrated circuit (IC) die comprising the stack of semiconductor structures, the source structure, the drain structure, the gate structure, and the spacer structure; and
a power supply coupled to the IC die.

10. A method, comprising:
receiving a multilayer stack comprising a stack of semiconductor structures interleaved with a stack of sacrificial structures, the semiconductor structures each comprising silicon and the sacrificial structures each comprising silicon and germanium;
epitaxially growing a source structure and a drain structure from opposing first and second ends of the multilayer stack;
removing portions the sacrificial structures to form lateral material structures adjacent the first and second ends of the multilayer stack;
oxidizing the lateral material structures to form spacer structures comprising a compound of silicon, germanium, and oxygen; and
forming a gate structure vertically between the stack of semiconductor structures and laterally adjacent the spacer structures.

11. The method of claim 10, wherein said oxidizing the spacer structures comprises oxidation at an average temperature of not more than 700°C for not more than 30 minutes.

12. The method of claim 11, wherein the oxidation comprises a peak temperature of not less than 500°C and not more than 700°C.

13. The method of any one of claims 10 to 12, wherein the spacer structure comprises a first portion adjacent the source structure or the drain structure and a second portion adjacent the gate structure, wherein the first portion has a greater germanium concentration than the second portion.

14. The method of any one of claims 10 to 13, wherein the spacer structure comprises a concave surface extending toward the source structure or the drain structure.

15. The method of any one of claims 10 to 14, wherein, after said oxidizing, a portion of at least one of the lateral material structures remains adjacent at least one of the spacer structures, the portion of the at least one of the lateral material structures substantially absent oxygen.
